# FASCICULE DE BREVET EUROPEEN

(11) **EP 3 499 656 B1**
(45) Date de publication et mention de la délivrance du brevet: **01.07.2020**
(21) Numéro de dépôt: 18206628.2
(22) Date de dépôt: 16.11.2018
(51) Int. Cl.: H01S 5/068, H01S 5/062, H01S 5/0683, H01S 5/02, H01S 5/022, H01S 5/0687, H01S 5/06

(54) **ÉMETTEUR D'UN SIGNAL OPTIQUE MONOCHROMATIQUE**
SENDER EINES MONOCHROMATISCHEN OPTISCHEN SIGNALS
TRANSMITTER OF A MONOCHROMATIC OPTICAL SIGNAL

(30) Priorité: 12.12.2017 FR 1761985
(43) Date de publication de la demande: 19.06.2019
(73) Titulaire: Commissariat à l'Énergie Atomique et aux Énergies Alternatives, 75015 Paris (FR)
(72) Inventeur: MENEZO, Sylvie, 38500 VOIRON (FR)
(74) Mandataire: Colombo, Michel

(56) Documents cités:
- US-A1- 2017 141 852
- CROZATIER VINCENT ET AL: "Phase locking of a frequency agile laser", APPLIED PHYSICS LETTERS, A I P PUBLISHING LLC, US, vol. 89, no. 26, 28 décembre 2006 (2006-12-28), pages 261115-261115, XP012087835, ISSN: 0003-6951, DOI: 10.1063/1.2424659
- OHTSU M ET AL: "LINEWIDTH REDUCTION OF A SEMICONDUCTOR LASER BY ELECTRICAL FEEDBACK", IEEE JOURNAL OF QUANTUM ELECTRONICS, IEEE SERVICE CENTER, PISCATAWAY, NJ, USA, vol. QE-21, no. 12, 1 décembre 1985 (1985-12-01), pages 1905-1912, XP000705754, ISSN: 0018-9197, DOI: 10.1109/JQE.1985.1072610

## Description

L'invention concerne un émetteur d'un signal optique monochromatique.

Les sources laser, et en particulier les sources laser à semi-conducteur, présentent ce qui est connu sous le terme de *«bruit de fréquence».* Ce bruit de fréquence a pour conséquence que la fréquence d'un laser monochromatique a une certaine largeur fréquentielle Δv_{SL} à la fréquence v_{SL} d'émission de la source laser. La largeur Δv_{SL} est également connue sous le terme de « largeur de raie ». Typiquement, si rien n'est fait pour compenser le bruit de fréquence, la largeur Δv_{SL} est généralement supérieure à 1 MHz et, le plus souvent, comprise entre 1 MHz et 5 MHz ou 1 MHz et 10 MHz dans le cas de sources laser à semi-conducteur. La largeur Δv_{SL} est définie ici comme étant la largeur, à mi-hauteur, de la raie du spectre de puissance, c'est-à-dire à la moitié de la puissance maximale de cette raie.

De telles largeurs Δv_{SL} ne sont pas compatibles avec certaines applications comme par exemple la mise en œuvre d'une technique de modulation FMCW (« *frequency modulated continuous wave* »). Il a donc été proposé de combiner dans un même émetteur une source laser à semi-conducteur avec une boucle de rétroaction qui diminue sa largeur de raie.

Ainsi, des émetteurs connus d'un signal optique monochromatique comportent :
- une source laser à semi-conducteur apte à émettre le signal optique à une fréquence v_{SL}, cette source laser comportant au moins une entrée de commande pour recevoir un courant d'injection apte à modifier la fréquence v_{SL} et au moins une sortie par laquelle est émis le signal optique, cette source laser émettant le signal optique à une fréquence v₀ en absence de courant d'injection,
- une boucle de rétroaction apte à produire un courant d'injection apte réduire la largeur de raie du signal optique, cette boucle de rétroaction étant raccordée, d'un côté, à la sortie de la source laser et, d'un côté opposé, à l'entrée de commande de la source laser pour injecter dans la source laser le courant d'injection produit, cette boucle de rétroaction comportant à cet effet un filtre optique présentant une bande passante, cette bande passante étant délimitée au moins d'un côté par un bord qui varie de façon continûment croissante ou décroissante sur un intervalle de fréquences contenant la fréquence v₀, ce bord contenant un point de fonctionnement prédéterminé correspondant à une fréquence vb contenue dans cet intervalle de fréquences, ce filtre optique étant raccordé à la sortie de la source laser pour recevoir le signal optique et comportant une sortie par laquelle est émise le signal optique filtré et à partir duquel le courant d'injection est produit.

Par exemple, de tels émetteurs connus sont divulgués dans les articles suivants :
- Vincent CROZATIER et AL : « Phase locking of a frequency agile laser », Applied Physics Letters 89, 261115 (2006), et
- Motoichi OHTSU et Al : « Linewidth Réduction of a semiconductor Laser by Elecrical Feedback », IEEE Journal of quantum electronics, vol. QE-21, 12/12/1985.

L'émetteur décrit dans l'article de Vincent CROZATIER est avantageux en ce qu'il permet à la fois de moduler la fréquence v_{SL} et de réduire la largeur Δv_{SL}. Dans cet émetteur connu, la boucle de rétroaction comporte un interféromètre de Mach-Zender dont l'une des branches est réalisée à l'aide d'une fibre optique de longueur L. Dans cet émetteur, la longueur L doit être la plus grande possible pour maximiser la sensibilité de la boucle de rétroaction. Cette longueur L ne doit pas être trop grande non plus. En effet, il a été montré que la bande passante de la boucle de rétroaction est inversement proportionnelle au délai Td = n.L/c, où n est l'indice de propagation dans la fibre optique, c la célérité de la lumière et le symbole « . » désigne l'opération de multiplication. De façon à avoir une boucle de rétroaction de bande passante de quelques méga-hertz, correspondant à la largeur de raie du laser avant réduction, le délai Td est maximisé à 250 ns. Cela correspond à une longueur L de 60 mètres. Ainsi, cet émetteur connu est encombrant. De plus, à cause de la longueur des branches de l'interféromètre de Mach-Zender, cet émetteur est sensible aux vibrations et aux variations de température. Il faut donc le stabiliser en température et l'isoler des vibrations. Également, toujours à cause de la longueur de la branche de l'interféromètre de Mach-Zender, la bande passante de la boucle de rétroaction est limitée à 2,5 MHz. Ainsi, si le spectre de puissance du bruit de fréquence s'étend sur une largeur supérieure à 2,5 MHz, celui-ci ne peut pas être complètement éliminé par la boucle de rétroaction. Cet émetteur a toutefois l'avantage de pouvoir fonctionner en présence d'une modulation de la fréquence de la source laser.

L'émetteur décrit dans l'article Motoichi OHTSU permet aussi de réduire la largeur de raie de la source laser. Par contre, pour cela, la température de la source laser doit être asservie sur une consigne de température qui permet de réduire sa largeur de raie. Le mécanisme d'asservissement de la température de la source laser est encombrant. Par ailleurs, l'émetteur proposé dans l'article Motoichi OHTSU n'est pas compatible avec une modulation de la fréquence de la source laser.

L'invention vise à réduire l'encombrement des émetteurs connus de signal optique monochromatique sans augmenter, voire même en réduisant, leur sensibilité aux variations de température ou aux vibrations. Elle a donc pour objet un tel émetteur conforme à la revendication 1.

Les modes de réalisation de cet émetteur peuvent comporter une ou plusieurs des caractéristiques des revendications dépendantes.

L'invention sera mieux comprise à la lecture de la description qui va suivre, donnée uniquement à titre d'exemple non-limitatif et faite en se référant aux dessins, sur lesquels :
- la figure 1 est une illustration schématique d'un émetteur d'un signal optique modulé en fréquence comportant un filtre ;
- les figures 2 et 3 sont des illustrations schématiques de deux spectres de transmission du filtre utilisé dans l'émetteur de la figure 1 ;
- la figure 4 est un graphe illustrant l'évolution au cours du temps d'un signal électrique de modulation reçu par l'émetteur de la figure 1 ;
- les figures 5 à 6 sont des illustrations schématiques d'autres modes de réalisation de l'émetteur de la figure 1 ;
- la figure 7 est une illustration schématique de la bande passante d'un filtre électrique mis en œuvre dans le mode de réalisation de la figure 6 ;
- la figure 8 est une illustration schématique d'un autre mode de réalisation d'une source laser susceptible d'être mise en œuvre dans l'émetteur de la figure 1.

### Chapitre I : Définitions et notations :

Dans ces figures, les mêmes références sont utilisées pour désigner les mêmes éléments. Dans la suite de cette description, les caractéristiques et fonctions bien connues de l'homme du métier ne sont pas décrites en détail.

Dans ce texte, le terme *« raccordé »* est utilisé pour désigner *« raccordé optiquement »* et, en alternance, *« raccordé électriquement ».* Par la suite, lorsque le type de raccordement, c'est-à-dire optique ou électrique, ressort clairement du contexte, seul le terme *« raccordé »* est employé sans préciser s'il s'agit d'un raccordement optique ou électrique.

Par puissance ou intensité d'un signal optique, on désigne, pour un signal optique monochromatique, le produit du champ optique E de ce signal optique par le conjugué de ce champ optique E. Le champ optique correspond au champ électrique E dans le cadre des ondes électromagnétiques et des équations de Maxwell.

Par composante fréquentielle d'un signal, on désigne une composante non-nulle du spectre de puissance de ce signal à une fréquence donnée. Une composante fréquentielle correspond donc à une raie du spectre de puissance.

Par « composante continue », on désigne la composante fréquentielle à la fréquence nulle.

### Chapitre II : Exemples de modes de réalisation

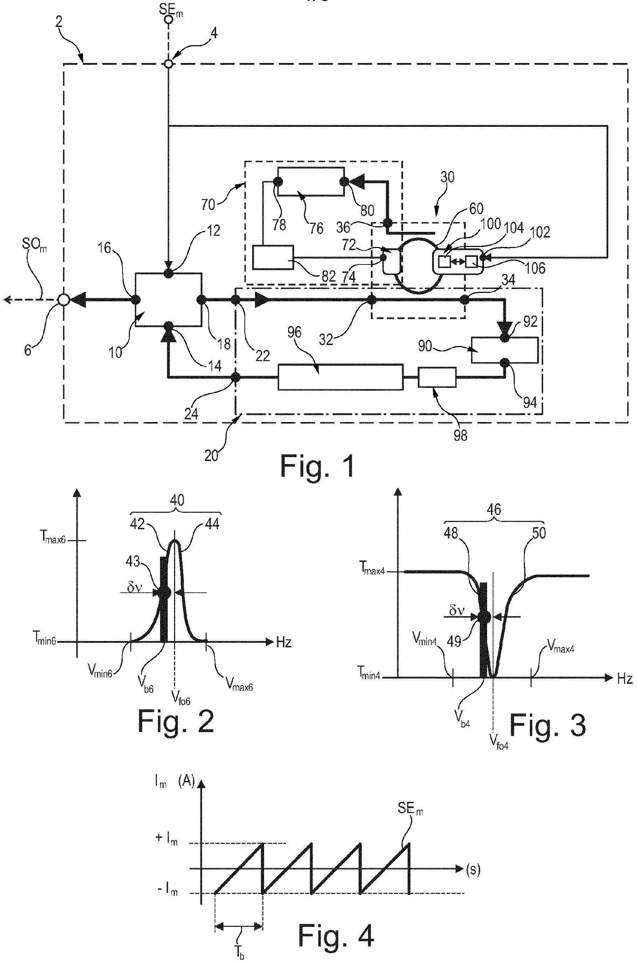

La figure 1 représente un émetteur 2 d'un signal optique modulé en fréquence. L'émetteur 2 comporte à cet effet :
- une entrée 4 destinée à recevoir un signal électrique de modulation SEₘ et,
- une sortie 6 par laquelle est émis le signal optique SOₘ₆ modulé en fonction du signal SEₘ.

L'émetteur 2 comporte une source laser 10 à semi-conducteur qui émet un signal optique monochromatique à la fréquence v_{SL}. À cause du bruit de fréquence, la largeur Δv_{SL} de la raie laser d'une telle source laser à semi-conducteur est généralement comprise entre 1 MHz et 10MHz. Ici, elle est de quelques méga-Hertz et, par exemple, égale à 5 MHz. Pour certaines sources laser, cette largeur Δv_{SL} peut atteindre 10 MHz.

Par exemple, ici, la source laser 10 est une source laser connue sous l'acronyme DBR (« Distributed Bragg Reflector laser »).

La source laser 10 a une entrée 12 destinée à recevoir le signal SEₘ, une entrée 14 destinée à recevoir un courant électrique d'injection, une première sortie 16 sur laquelle est émis le signal optique SOₘ₆ utile, et une seconde sortie 18 sur laquelle est émis un signal optique SOₘ₂₀ utilisé pour réduire la largeur Δv_{SL}.

Le signal SOₘ₂₀ est identique au signal SOₘ₆ sauf que sa puissance peut être différente. Par exemple, la puissance du signal SOₘ₂₀ est inférieure à la puissance du signal SOₘ₆. A titre d'illustration, la puissance du signal SOₘ₂₀ est cinq fois, et de préférence dix fois, inférieure à la puissance du signal SOₘ₆. Ici, par exemple, la puissance du signal SOₘ₂₀ est dix fois inférieure à la puissance du signal SOₘ₆.

L'entrée 12 est directement raccordée à l'entrée 4 et la sortie 16 est directement raccordée à la sortie 6.

Le signal SEₘ permet de moduler la fréquence v_{SL}. Ici, le signal SEₘ est un courant électrique appliqué sur l'entrée 12 et dont l'intensité est modulée dans le temps. Cette modulation du signal SEₘ provoque une modulation ou un déplacement correspondant de la fréquence v_{SL}. Plus précisément, la fréquence v_{SL} varie par rapport à une fréquence libre v₀ de la source laser 10. Cette variation est proportionnelle à l'intensité du courant reçu sur l'entrée 12. La fréquence v₀ de la source laser 10 est la fréquence du signal monochromatique émis par cette source laser en l'absence de signaux reçus sur son entrée 12. Cette fréquence v₀ est une caractéristique intrinsèque de la source laser 10. La fréquence v₀ varie uniquement lentement, par exemple, en fonction de perturbations extérieures telle qu'une variation de température.

Un exemple de signal SEₘ est représenté sur la figure 4. Sur cette figure, l'axe des ordonnées est gradué en ampères et l'axe des abscisses en secondes. Dans cet exemple, le signal SEₘ est périodique de période T_{b}. La période T_{b} est égale à 1/f_{b}, où f_{b} est la fréquence harmonique de rang 1, également appelée fréquence fondamentale, du signal SEₘ.

Sur une période T_{b}, le signal SEₘ varie linéairement de -Iₘ à +Iₘ. Avec un tel signal en dents de scie, le spectre de puissance du signal SEₘ est constitué de raies aux fréquences f_{b}, 3f_{b}, 5f_{b}, ..., (2n+1)f_{b}, où n est un nombre entier. L'amplitude de ces raies décroit au fur et à mesure que n croit.

Cette fréquence fb peut être quelconque. Toutefois, en pratique, la fréquence fb est généralement supérieure à 1kHz, 10 kHz ou 100 kHz. Dans ce mode de réalisation, la fréquence fb est égale à 100kHz.

Pour réduire la largeur Δv_{SL}, l'émetteur 2 comporte une boucle 20 de rétroaction. Cette boucle 20 comporte une entrée 22 qui reçoit le signal SOₘ₂₀ et une sortie 24 par laquelle est émis un courant d'injection produit pour réduire la largeur Δv_{SL}. L'entrée 22 est raccordée à la sortie 18. La sortie 24 est directement raccordée à l'entrée 14 de la source laser 10 pour rétro-injecter le courant d'injection.

La boucle 20 comporte un filtre optique 30 équipé d'une entrée 32 directement raccordée à l'entrée 22. Le filtre 30 comporte deux sorties 34 et 36 sur lesquelles sont émis des signaux optiques filtrés, respectivement SO₃₄ et SO₃₆, construits à partir du signal SOₘ₂₀ reçu sur l'entrée 32.

Le spectre de transmission T₂₋₆ du filtre 30 entre l'entrée 32 et la sortie 36 est représenté sur la figure 2. Le spectre de transmission T₂₋₄ du filtre 30 entre l'entrée 32 et la sortie 34 est représenté sur la figure 3. Sur ces figures 2 et 3, le spectre de la source laser 10 est également représenté, schématisé par une unique composante fréquentielle à la fréquence v_{SL}. Sur ces figures, l'axe des abscisses représente la fréquence optique fₒₚₜ. L'axe des ordonnées représente le ratio de transmission de la puissance optique entre l'entrée 32 et la sortie correspondante 34 ou 36 du filtre 30. Ici, pour simplifier les figures 2 et 3, seules les portions des spectres de transmission T₂₋₄ et T₂₋₆ intéressantes pour la compréhension du fonctionnement de l'émetteur 2 sont représentées.

Le spectre T₂₋₆ présente un maximum Tₘₐₓ₆ à la fréquence v_{fo6}. Ici, le spectre T₂₋₆ est par exemple une fonction lorentzienne centrée sur la fréquence v_{fo6}. Cette fonction peut être une sinusoïde, une gaussienne, une fonction porte ou autres. De part et d'autre de la fréquence v_{fo6}, le spectre T₂₋₆ présente des bords, respectivement, 42 et 44, montant et descendant. Le bord 42 est une fonction monotone qui croît continûment depuis un minimum Tₘᵢₙ₆ jusqu'au maximum Tₘₐₓ₆ sur un intervalle de fréquences [vₘᵢₙ₆;v_{fo6}]. Le bord 44 est une fonction monotone qui décroît continûment depuis le maximum Tₘₐₓ₆ jusqu'au minimum Tₘᵢₙ₆ sur un intervalle de fréquences [v_{fo6};vₘₐₓ₆]. Le long de l'un des bords 42 et 44, un point particulier, appelé par la suite « point de fonctionnement », est choisi. Ce point est particulier en ce que la fonction monotone présente, au niveau de ce point, des propriétés géométriques souhaités et, généralement, avantageuses pour le fonctionnement de l'émetteur 2. Ici, le point de fonctionnement choisi correspond au point pour lequel la valeur absolue de la pente du bord est maximale. Par exemple, les bords 42 et 44 présentent chacun un point d'inflexion et la valeur absolue de la pente est maximale au niveau de ce point d'inflexion. Ici, le point de fonctionnement est choisi sur le bord 42 et porte la référence numérique 43. La fréquence en abscisse du point 43 est notée v_{b6}. Au niveau de ce point 43, le bord 42 est pratiquement une droite. Ainsi, au niveau de ce point 43, le bord 42 est approximé par une fonction linéaire de la forme *T*=a₆.(*fₒₚₜ-v*_{*b*6})+*b*₆, où les coefficients a₆ et b₆ sont indépendants de la fréquence optique fₒₚₜ.

Le spectre T₂₋₄ présente un minimum Tₘᵢₙ₄ à une fréquence v_{fo4}. De part et d'autre de la fréquence v_{fo4}, le spectre T₂₋₄ présente des bords, respectivement, 48 et 50, descendant et montant. Le bord 48 est une fonction monotone qui décroît continûment depuis un maximum Tₘₐₓ₄ jusqu'au minimum Tₘᵢₙ₄ sur un intervalle de fréquences [vₘᵢₙ₄;v_{fo4}]. Le bord 50 est une fonction monotone qui croît continûment depuis le minimum Tₘᵢₙ₄ jusqu'au maximum Tₘₐₓ₄ sur un intervalle de fréquences [v_{fo4};vₘₐₓ₄]. Pour chacun des bords 48 et 50, il existe un point au niveau duquel la valeur absolue de la pente du bord est maximale. Par exemple, les bords 48 et 50 présentent chacun un point d'inflexion et la valeur absolue de la pente est maximale au niveau de ce point d'inflexion. De façon similaire à ce qui a été décrit pour le point 43, un point de fonctionnement 49 est ici choisi le long du bord 48. La fréquence en abscisse du point 49 est notée v_{b4}. Comme pour le point 43, au niveau de ce point 49, le bord 48 peut être approximée par une droite. Ainsi, au niveau de ce point 49, le bord 48 est approximé par une fonction linéaire de la forme *T*=*a*₄*·*(*fₒₚₜ* - v_{*b*4})+*b*₄, où les coefficients a₄ et b₄ sont indépendants de la fréquence optique fₒₚₜ.

Les fréquences vb4 et vb6 sont égales, et sont notées par la suite v_{b}. De plus, ici, les fréquences v_{fo4} et v_{fo6} sont aussi égales, et sont notées par la suite v_{fo}. Dans la suite de cette description, on note δv, l'écart entre les fréquences v_{b} et v_{fo}.

Dans ce mode de réalisation, le filtre 30 est un filtre optique à anneau résonant connu sous le terme anglais de *« optical ring resonator ».* Les filtres optiques à anneaux résonnants sont bien connus. En particulier, les propriétés des spectres T₂₋₆ et T₂₋₄ suivant les paramètres géométriques de l'anneau et des bus optiques de couplage à l'anneau sont biens connues. Ainsi, par la suite seuls quelques détails sont donnés. Le filtre 30 comporte un anneau 60, un premier bus optique et un second bus optique. L'anneau 60 est un guide d'onde qui forme une boucle fermée. L'entrée 32 et les sorties 34, 36 correspondent aux ports classiquement appelés, respectivement, port « in », port « through » et port « drop ». Les premier et second bus optiques sont des guides d'ondes. Ils sont couplés optiquement chacun, généralement par leur partie intermédiaire, à l'anneau 60. Ici, l'un de ces bus s'étend entre l'entrée 32 et la sortie 34 et l'autre de ces bus raccorde optiquement la sortie 36 à l'anneau 60.

Dans l'émetteur 2, la fréquence vb doit être égale à la fréquence v₀. Pour cela, l'émetteur 2 comporte une boucle 70 d'asservissement permettant de positionner le spectre T₂₋₆ de sorte que la fréquence vb soit égale à la fréquence v₀. En effet, même si l'on vise en conception à fabriquer la source laser 10 et le filtre 30 de telle sorte que les fréquences v_{b} et v₀ soit égales, à cause des erreurs de fabrication, ces fréquences ne sont généralement pas égales. Il faut donc au démarrage de l'émetteur 2, aligner ces deux fréquences v_{b} et v₀. Ici, cela est fait en translatant les spectres T₂₋₄ et T₂₋₆ du filtre 30 le long de l'axe des fréquences.

De plus, au cours du fonctionnement de l'émetteur 2, le filtre 30 et la source laser 10 peuvent subir des perturbations qui modifient la position du spectre T₂₋₆ de sorte que les fréquences v_{b} et v₀ ne sont plus égales. Il s'agit de perturbations lentes qui s'appliquent différemment sur la source laser 10 et le filtre 30. Ces perturbations sont typiquement des variations de température différentes entre la source laser 10 et le filtre 30 ou des vibrations perçues différemment par la source laser 10 et filtre 30. Ici, la boucle 70 a donc également pour fonction de maintenir la position du spectre T₂₋₆ de sorte que les fréquences v_{b} et v₀ restent égales en dépit des erreurs de fabrication et des perturbations lentes.

A cet effet, la boucle 70 comprend un actionneur 72 apte à déplacer fréquentiellement le spectre T₂₋₆. Il est connu de l'homme de l'art que puisque le filtre 30 comporte des éléments communs aux sorties 34 et 36, comme l'anneau 60, les spectres T₂₋₆ et T₂₋₄ se déplacent fréquentiellement systématiquement ensemble et de la même manière. Ainsi, l'actionneur 72 déplace simultanément les spectres T₂₋₆ et T₂₋₄.

L'actionneur 72 comporte une entrée 74 pour recevoir un signal électrique de commande. L'actionneur 72 déplace le spectre T₂₋₆ en fonction de ce signal électrique de commande. Par exemple, l'actionneur 72 est une chaufferette disposée à proximité d'une section de l'anneau 60. Cette chaufferette est apte à chauffer cette section de l'anneau 60 pour faire varier l'indice de réfraction du matériau qui forme cet anneau 60. Des exemples de réalisation d'une telle chaufferette permettant de modifier l'indice de réfraction d'un guide d'onde sont décrits, par exemple, dans l'article suivant : JE Cunningham et. Al. dans « *Highly-efficient thermally-tuned resonant optical filters»,* Optical Express. 08/2010. Par conséquent, la réalisation de l'actionneur 72 n'est pas décrite ici en détail.

La boucle 70 comporte aussi un photodétecteur 76 capable de générer un signal électrique SE₇₈ représentatif de l'écart entre les fréquences v_{b} et v₀. Le photodétecteur 76 comporte :
- une sortie 78 par laquelle est émis le signal SE₇₈, et
- une entrée 80 raccordée à la sortie 36 pour recevoir au moins une fraction du signal optique filtré par le spectre T₂₋₆ du filtre 30.

Par exemple, le photodétecteur 76 est une photodiode.

Enfin, la boucle 70 comporte un circuit 82 de commande capable, à partir du signal électrique SE₇₈, de générer un signal électrique SE₇₄ de commande de l'actionneur 72 qui maintient les fréquences v_{b} et v₀ égales. Ce signal SE₇₄ est transmis sur l'entrée 74 de l'actionneur 72.

De nombreux modes de réalisation différents du circuit 82 sont possibles. Par exemple, ici, le circuit 82 comprend une table T₈₂ préenregistrée de valeurs et un comparateur. La table T₈₂ comprend un ensemble de valeurs M₇₈ chacune associée à une valeur correspondante M₇₄ pour le signal SE₇₄. Les valeurs M₇₈ comprennent une valeur M_{b}, des valeurs Mᵢ inférieures à la valeur M_{b}, et des valeurs Mₛ supérieures à la valeur M_{b}. La valeur M_{b} est égale à la valeur du signal SE₇₈ lorsque les fréquences v_{b} et v₀ sont égales. Le comparateur compare le signal SE₇8 aux valeurs M₇₈ puis génère un signal SE₇₄ à partir de la ou des valeurs M₇₄ associées aux valeurs M₇₈ les plus proches de la valeur actuelle du signal SE₇₈. Quand le signal électrique SE₇₈ est inférieur à la valeur M_{b}, le circuit 82 génère un signal électrique SE₇₄ dimensionné pour décaler le spectre T₂₋₆ vers la gauche. En effet, lorsque le spectre T₂₋₆ du filtre 30 est positionné de telle façon que la fréquence v_{b} est supérieure à la fréquence v₀, la puissance optique sur la sortie 36 du filtre 30 est inférieure à P_{b}, P_{b} étant la puissance égale à la puissance du signal SO₃₆ lorsque les fréquences v_{b} et v₀ sont égales. Le signal SE₇₈ prend alors une valeur Mᵢ inférieure à la valeur M_{b}. A l'inverse, quand le signal SE₇₈ est supérieur à la valeur M_{b}, le circuit 82 génère un signal SE₇₄ dimensionné pour décaler le spectre T₂₋₆ vers la droite.

La boucle 70 est dimensionnée pour être effective sur une plage de fréquences [0 Hz, f_{c70}], où f_{c70} est la fréquence de coupure à - 3 dB de la boucle 70. Étant donné que les perturbations compensées par la boucle 70 sont lentes, la fréquence f_{c70} est faible, c'est-à-dire inférieure à 5 kHz dans le cas où les perturbations sont des variations de température ou des vibrations. Ici, la fréquence f_{c70} est égale à 1 kHz.

Pour réduire le bruit de fréquence de la source laser 10, la boucle 20 utilise la sortie 34 du filtre 30. Elle comporte, en plus du filtre 30, un photodétecteur 90. Le photodétecteur 90 mesure la puissance du signal optique SO₃₄ transmis sur la sortie 34 et génère, sur une sortie 94, un signal électrique SE₉₄ proportionnel à la puissance du signal optique SO₃₄. Le photodétecteur 90 comporte à cet effet une entrée 92 directement raccordée à la sortie 34. Par exemple, le photodétecteur 90 est une photodiode.

Dans ce mode de réalisation, la sortie 94 est raccordée à la sortie 24 de la boucle 20 seulement par l'intermédiaire d'un filtre électrique 98 et d'un amplificateur 96.

Le filtre 98 comporte au moins une bande interdite qui élimine ou atténue la composante continue du signal SE₉₄. Cette bande interdite comprend donc la fréquence 0 Hz. En plus, le filtre 98 est apte à éliminer ou atténuer sélectivement les amplitudes des composantes fréquentielles générées par la boucle 70 sur le signal optique SO₃₄. En effet, la boucle 70 déplace le spectre T₂₋₆, et donc le spectre T₂₋₄, pour que la fréquence v_{b} reste égale à la fréquence v₀ actuelle. Les déplacements de la fréquence v_{b} par la boucle 70 génèrent des modifications de la puissance du signal optique SO₃₄ qui ne sont pas causées par le bruit de fréquence. Ces déplacements de la fréquence v_{b} se produisent à une fréquence inférieure à la fréquence f_{c70}. Par conséquent, les composantes fréquentielles générées par la boucle 70 sont essentiellement comprises dans la plage [0 Hz ; f_{c70}]. Dans ce mode de réalisation, on considère que la partie du spectre de fréquence du signal SO₃₄ principalement générée par la boucle 70 s'étendent continûment sur cette plage [0 Hz ; f_{c70}]. Dans ces conditions, à titre d'illustration, le filtre 98 est un filtre électrique passe-haut dont la fréquence de coupure f_{c98} à -3 dB est supérieure ou égale à la fréquence f_{c70}. Généralement, la fréquence f_{c98} est inférieure à 1 MHz et/ou à la fréquence f_{b}. De préférence, cette fréquence f_{c98} est comprise entre f_{c70} et 1,3f_{c70} ou entre f_{c70} et 1,1f_{c70}. Ici, le filtre 98 est placé avant l'amplificateur 96 entre la sortie 94 et la sortie 24 pour atténuer les composantes fréquentielles produites par la boucle 70 sur le signal SO₃₄.

Grâce au filtre 98, les modifications de la puissance mesurée par le photodétecteur 90 qui sont causées par la boucle 70 ne sont pas compensées par la boucle 20. La boucle 20 ne neutralise donc pas le fonctionnement de la boucle 70. De plus, la boucle 20 reste apte à réduire la largeur Δv_{SL} car la partie du spectre de puissance du signal SO₃₄ générée par le bruit de fréquence est principalement située au-delà de la fréquence f_{c70}. Par conséquent, le filtre 98 n'empêche pas de réduire la largeur Δv_{SL}.

L'amplificateur 96 multiplie le signal électrique en sortie du filtre 98 par un gain G2. Ici, étant donné que le bord 48 est un bord descendant, pour obtenir une contre-réaction négative, le gain G2 est positif.

La boucle 20 est dimensionnée pour être effective sur une plage de fréquences [f_{c98}, f_{c20}], où f_{c20} est la fréquence de coupure de la boucle 20. Typiquement, pour réduire efficacement la largeur Δv_{SL}, la fréquence f_{c20} est choisie égale ou supérieure à Δv_{SL0}/2 ou Δv_{SL0}, où Δv_{SL0} est la largeur Δv_{SL} de la raie de la source laser 10 en absence de la boucle 20. De préférence, la fréquence f_{c20} est aussi choisie inférieure ou égale à 1,2Δv_{SL0}/2 ou 1,2Δv_{SL0}. Ainsi, la fréquence f_{c20} est généralement comprise entre 0,5 MHz et 10 MHz ou 12 MHz. Ici, si l'on considère que la largeur Δv_{SL0} est de 5 MHz , la fréquence f_{c20} est choisie, par exemple, égale à 5 MHz.

Dans ces conditions, le bruit de fréquence de la source laser 10 compris entre 1 kHz et 5 MHz est annulé suivant le mécanisme suivant. Une augmentation de la fréquence v₀ par rapport à la fréquence v_{b}, se traduit par une réduction de la puissance optique du signal SO₃₄ reçu par le photodétecteur 90. Le courant électrique en sortie du photodétecteur 90 est donc diminué. Le courant d'injection injecté sur l'entrée 14 est également diminué. Cette diminution du courant d'injection donne lieu à une diminution de la fréquence v₀ qui permet de se rapprocher de la fréquence v_{b}. Une diminution de la fréquence v₀ par rapport à la fréquence v_{b}, se traduit par une augmentation de la puissance optique du signal SO₃₄ reçu par le photodétecteur 90. Le courant électrique en sortie du photodétecteur 90 est donc augmenté. Le courant d'injection est également augmenté. Cette augmentation du courant d'injection donne lieu à une augmentation de la fréquence laser v₀, permettant donc de se rapprocher de la fréquence v_{b}.

Si rien de particulier n'est fait, au moins certaines des composantes fréquentielles du signal SOₘ₆ causées par la modulation de fréquence sont éliminées ou fortement atténuées par la boucle 20 au même titre que le bruit de fréquence de la source laser 10. En effet, la fréquence fondamentale f_{b}, et ici aussi les fréquences 3f_{b}, 5f_{b} ...etc, du signal SEₘ sont comprises dans la plage de fréquences [f_{c98}, f_{c20}]. Par conséquent, si rien n'est fait pour éviter cela, les composantes fréquentielles du signal SEₘ à des fréquences inférieures à la fréquence f_{c20} ne permettent pas de moduler la fréquence v_{SL} car elles sont annulées par la boucle 20.

Dans ce mode de réalisation, pour arriver à la fois à moduler la fréquence v₀ tout en réduisant la largeur Δv_{SL}, l'émetteur 2 comporte un modulateur 100 capable de moduler le spectre T₂₋₄, et donc le spectre T₂₋₆, du filtre 30 de la même façon que le signal SEₘ module la fréquence v_{SL} de la source laser 10. Par « *de la même façon »,* on désigne le fait que la fréquence v_{b} se déplace à la même vitesse, avec la même amplitude et en même temps que la fréquence v_{SL} de la source laser 10.

Pour cela, le modulateur 100 comporte une entrée 102 de commande qui reçoit le signal SEₘ. L'entrée 102 est directement raccordée à l'entrée 4 de l'émetteur 2. Le modulateur 100 comporte :
- un actionneur 104 apte à déplacer les spectres T₂₋₄ et T₂₋₆ du filtre 30 en réponse à un signal de commande électrique SE₁₀₆, et
- un circuit 106 de commande apte, à partir du signal SEₘ, à générer le signal SE₁₀₆ qui permet de déplacer les spectres T₂₋₄ et T₂₋₆ de la même façon que la fréquence v_{SL} est déplacée .

Par exemple, l'actionneur 104 comporte une jonction P-N réalisée dans une portion de l'anneau 60 et des électrodes permettant de faire varier la densité des porteurs de charge au niveau de cette jonction P-N. Une variation de la densité des porteurs de charge au niveau de la jonction P-N permet de faire varier rapidement l'indice de réfraction de l'anneau 60 et donc de déplacer rapidement les spectres T₂₋₄ et T₂₋₆. Cette technique est par exemple décrite dans l'article suivant : Giovanni Beninca de Farias et. Al. « Up to 64-QAM Modulation of a Silicon-Ring-Resonator-Modulator », OSA 2014. L'homme du métier sait donc comment réaliser l'actionneur 104 et le circuit 106. Ceux-ci ne sont donc pas décrits ici plus en détail.

Ici, comme la boucle 70, le modulateur 100 déplace à la fois les spectres T₂₋₄ et T₂₋₆.

Puisque la fréquence v_{b} est modulée de la même façon que la fréquence v_{SL}, la boucle 20 n'élimine pas les variations de la fréquence v_{SL} provoquée par la modulation de fréquence. Dès lors, l'émetteur 2 permet à la fois de moduler la fréquence v_{SL} tout en réduisant en permanence la largeur Δv_{SL}.

De préférence, pour augmenter encore plus la compacité de l'émetteur 2 et, en même temps, pour décroître sa sensibilité aux vibrations, l'ensemble des composants optiques de l'émetteur 2 décrits ici sont réalisés sur le même substrat. Par exemple, ces composants optiques sont réalisés à l'aide des mêmes procédés conventionnels de fabrication que ceux utilisés pour fabriquer des composants photoniques sur silicium. Ainsi, la source laser 10, le filtre 30 et les photodétecteurs 76 et 90 sont intégrés sur un même substrat appelé « puce » ou « die » en anglais. Par exemple, le procédé de fabrication utilisé est celui décrit dans l'article suivant : S. Menezo et Al : « Advances on III-V on Silicon DBR and DFB Lasers for WDM optical interconnects and Associated Heterogeneous Integration 200mm-wafer-scale Technology », Compound Semiconductor Integrated Circuit Symposium (CSICs), 2014 IEEE..

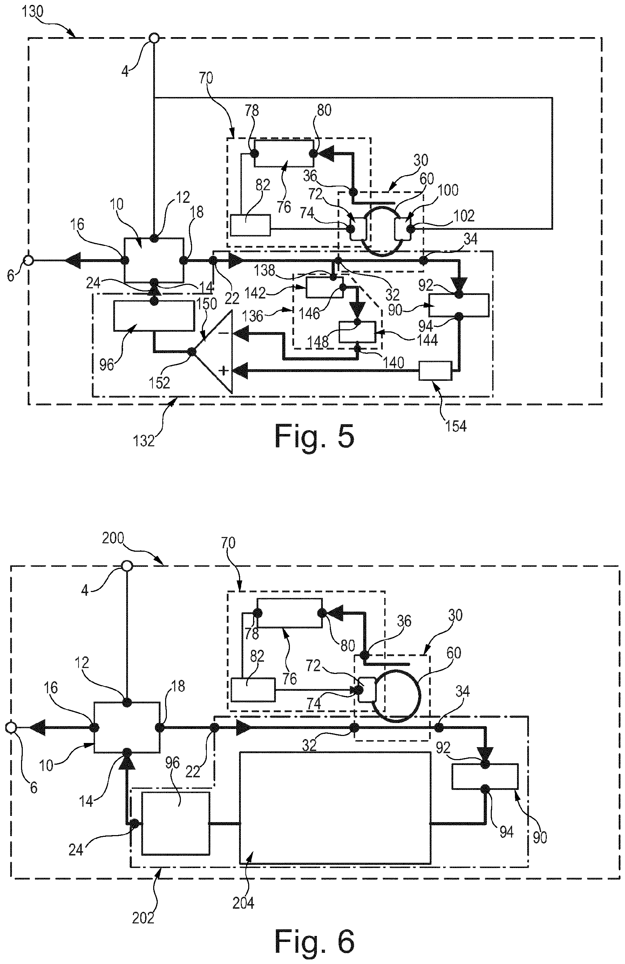

La figure 5 représente un émetteur 130 identique à l'émetteur 2, sauf que la boucle 20 est remplacée par une boucle 132. La boucle 132 est identique à la boucle 20 sauf que la boucle 132 comporte d'autres composants pour éliminer la composante continue de la puissance optique du signal SO₃₄ et conserver uniquement la contribution du bruit de fréquence. Par ailleurs, lorsqu'il existe un bruit de fréquence qui se traduit par une largeur Δv_{SL}, il existe en même temps un bruit d'intensité qui fait varier l'intensité de la raie de la source laser à la fréquence v_{SL}. Également, lorsque l'on module la fréquence de la source laser, il existe une modulation résiduelle de son intensité optique. Si rien n'est fait, le bruit d'intensité et la modulation résiduelle de l'intensité laser modifient l'intensité du courant d'injection sans que cette modification du courant d'injection contribue à la réduction de la largeur Δv_{SL}. Dans ce mode de réalisation, la boucle 132 est en plus conçue pour atténuer, voire éliminer, le bruit d'intensité ainsi que la modulation résiduelle de l'intensité.

Pour cela, la boucle 132 comporte un composant 136 qui fournit un signal électrique SE₁₄₀ de référence de la puissance optique laser, du bruit d'intensité et de la modulation résiduelle d'intensité.Ce composant 136 comporte une entrée 138 raccordée à l'entrée 22 pour recevoir le signal SOₘ₂₀ et une sortie 140 par laquelle est émis le signal électrique SE₁₄₀. L'intensité du signal SE₁₄₀ est fonction de, et de préférence égale à, la puissance de la raie laser, de son bruit d'intensité, et de la modulation résiduelle d'intensité sous l'effet du signal SEₘ₂₀. Par exemple, le composant 136 comporte à cet effet :
- un atténuateur variable 142 de puissance plus connu sous l'acronyme VOA (« *variable optical attenuator* »), et
- un photodétecteur 144.

L'atténuateur 142 atténue la puissance du signal SOₘ₂₀. Il comporte une entrée directement raccordée à l'entrée 138 pour recevoir le signal SOₘ₂₀. L'entrée 138 est raccordée à l'entrée 22 avant que le signal SOₘ₂₀ ne traverse le filtre 30. On rappelle ici que, classiquement, la puissance du signal optique SO₃₄ est atténuée par rapport à la puissance du signal optique SOₘ₂₀ reçue sur l'entrée 32.

L'atténuateur 142 comporte aussi une sortie 146 sur laquelle est émis un signal optique atténué SO₁₄₆ dont la puissance a été atténuée. Ici, l'atténuateur 142 est réglé pour que le coefficient d'atténuation de l'atténuateur 142 soit égal au coefficient d'atténuation du filtre 30. Le coefficient d'atténuation d'un composant optique est ici défini comme étant égal à la puissance du signal optique mesurée en sortie de ce composant optique divisée par la puissance de ce signal optique mesurée à l'entrée de ce même composant optique.

La sortie 146 est raccordée à une entrée 148 du photodétecteur 144. Le photodétecteur 144 convertit la puissance du signal SO₁₄₆ en un signal électrique appelé ici « signal SE₁₄₀ » et précédemment introduit. Le signal SE₁₄₀ est ensuite émis par l'intermédiaire de la sortie 140. Le signal SE₁₄₀, contrairement au signal SE₉₄, est indépendant des variations de la fréquence v_{b} du filtre 30. Autrement dit, le signal SE₉₄ est constitué de la somme d'un signal électrique égal au signal SE₁₄₀ et d'un signal électrique fonction du bruit de fréquence de la source laser et des variations liées à la boucle 70.

Dans ce mode de réalisation, le filtre 98 est remplacé par un filtre 154. Le filtre 154 élimine ou atténue uniquement l'amplitude des composantes fréquentielles du courant d'induction produites par la boucle 70. Par exemple, le filtre 154, contrairement au filtre 98, n'atténue pas nécessairement ou peu la composante continue du courant d'induction produit. Dans ce mode de réalisation, la composante continue est éliminée par une soustracteur décrit plus loin.

À cet effet, par exemple, le filtre 154 comporte une bande passante passe-bas et une bande passante passe-haut séparées l'une de l'autre par une bande interdite. A l'intérieur de la bande interdite, l'atténuation des composantes fréquentielles du courant d'injection produit est supérieure à -3 dB. Par exemple, la bande passante passe-haut est identique à la bande passante du filtre 98. La bande passante passe-bas présente une fréquence de coupure à -3 dB inférieure à 100 Hz ou 50 Hz.

La sortie 140 et la sortie du filtre 154 sont raccordées à des entrées respectives d'un soustracteur 150.

Le soustracteur 150 soustrait l'intensité du courant généré par le photodétecteur 144 à l'intensité du courant généré par le filtre 154 et émet sur une sortie 152 un courant d'injection dont l'intensité est le résultat de cette soustraction. La sortie 152 est raccordée à la sortie 24 de la boucle 132 par l'intermédiaire de l'amplificateur 96. Le courant d'injection ainsi construit ne compense que le bruit de fréquence de la source laser.

La figure 6 représente un émetteur 200 qui implémente une autre stratégie que celle précédemment décrite pour éviter que la boucle de rétroaction ne compense les composantes fréquentielles générées par la modulation de la fréquence v_{SL}. Plus précisément, la stratégie mise en œuvre dans ce mode de réalisation consiste à éliminer ou atténuer sélectivement, à l'aide du filtre électrique, l'amplitude des composantes fréquentielles du courant d'injection produit qui sont causées par la modulation de la fréquence v_{SL}.

L'émetteur 200 est ici identique à l'émetteur 2, sauf que la boucle 20 est remplacée par une boucle 202 et le modulateur 100 est omis. La boucle 202 est identique à la boucle 20, sauf que le filtre 98 est remplacé par un filtre électrique 204.

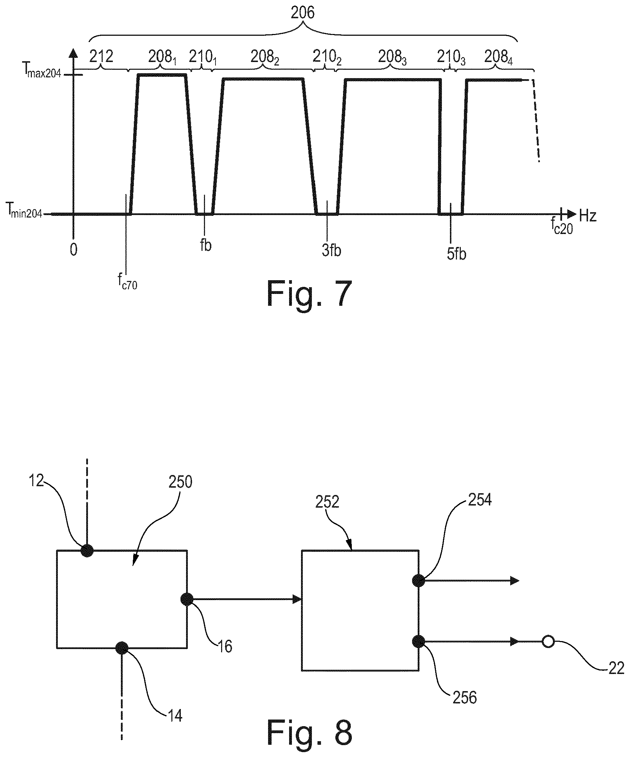

Le filtre 204 est conçu pour atténuer sélectivement l'amplitude des composantes fréquentielles du courant d'injection à la fréquence fondamentale f_{b} et aux harmoniques du signal SEₘ. Dans le cas particulier du signal SEₘ décrit en référence à la figure 4, les harmoniques du signal SEₘ sont des multiples entiers impairs de la fréquence fondamentale f_{b}. À cet effet, le filtre 204 est un filtre en peigne. Le spectre de transmission 206 du filtre 204 est représenté sur la figure 7.

Sur la figure 7, l'axe des abscisses est gradué en Hertz et l'axe des ordonnées représente le ratio de transmission de la puissance électrique entre l'entrée et la sortie du filtre 204. Le spectre 206 varie entre une valeur minimale Tₘᵢₙ₂₀₄ et une valeur maximale Tₘₐₓ₂₀₄. Sur la figure 7, la ligne en pointillés qui termine le spectre 206 indique que seul le début de ce spectre est représenté. Le spectre 206 comporte une multitude de bandes passantes 208ᵢ espacées les unes des autres par des bandes interdites 210ᵢ. L'indice i est un numéro d'ordre. À l'intérieur des bandes interdites 210ᵢ, l'atténuation du signal électrique est supérieure à -3 dB. Les bandes interdites 210ᵢ sont chacune centrées sur un multiple entier impair de la fréquence fondamentale fb. Par exemple, chaque bande interdite 210ᵢ est comprise entre 0,8(2k+1)f_{b} et 1,2(2k+1)f_{b} et, de préférence, entre 0,9(2k+1)f_{b} et 1,1(2k+1)f_{b}, où k est un entier égal à i-1.

Ici, le filtre 204 est en plus conçu pour remplir la même fonction que celle du filtre 98. À cet effet, le spectre 206 comporte en plus une bande interdite 212 qui s'étend entre 0 Hz et une fréquence de coupure supérieure ou égale à la fréquence f_{c70}.

Dans ce mode de réalisation, puisque les composantes fréquentielles générées par la modulation de la fréquence v_{SL} sont éliminées du courant d'injection produit par la boucle 202, cette boucle 202 ne compense pas cette modulation. Par conséquent, ce mode de réalisation permet lui aussi à la fois de moduler la fréquence v_{SL} tout en réduisant en permanence la largeur Δv_{SL} de la raie à la fréquence v_{SL}.

La source laser peut être une source laser DBR mais aussi DFB (« *Distributed FeedBack laser* »). Ces deux sources laser peuvent ne disposer que d'une seule sortie optique. La figure 8 représente une telle source laser 250 qui ne comporte qu'une seule sortie optique, c'est-à-dire ici la sortie 16. Cette source laser 250 comporte les mêmes entrées 12 et 14. Dans ce cas, pour utiliser la source laser 250 à la place de la source laser 10 dans l'un quelconque des émetteurs décrits ici, un diviseur optique 252 de puissance est raccordé à la sortie 16 de la source laser 250. Le diviseur 252 divise le signal optique SOₘ₁₆ émis sur la sortie 16 en deux signaux optiques identiques mais, éventuellement, de puissances différentes. L'un de ces signaux optiques est émis sur une sortie 254 et l'autre sur une sortie 256 du diviseur 252. Le rapport de puissance entre les signaux optiques émis sur les sorties 254 et 256 est choisi suivant les besoins entre 0,0001 et 0,9999. Par exemple, le rapport de puissance est le même que celui décrit pour les signaux SOₘ₆ et SOₘ₂₀. Dès lors, lorsque la source laser 250 et le diviseur 252 remplacent la source laser 10, c'est la sortie 256 qui est raccordée à l'entrée 22 de la boucle de rétroaction.

### Variantes de la source laser :

Tout ce qui a été décrit ici s'applique à d'autres sources laser à semi-conducteur qu'une source laser DBR ou DFB, à partir du moment où il est possible de moduler sa fréquence à partir d'un courant tel que le courant d'injection décrit ici. Par exemple, la source laser peut être une diode laser à cavité verticale connue sur l'acronyme VCSEL (« *Vertical-cavity* - *surface-emitting* - *laser* »).

Les entrées 12 et 14 ont été décrites jusqu'à présent comme étant des entrées distinctes de la source laser. Toutefois, ces entrées 12 et 14 peuvent être confondues de sorte que le signal SEₘ et le courant d'injection produit sont injectés dans la source laser par la même entrée. Dans ce cas, l'émetteur comporte par exemple un sommateur apte à ajouter le courant d'injection produit au signal SEₘ avant que le résultat de cette somme ne soit injecté sur l'entrée de la source laser.

Dans d'autres modes de réalisation, la puissance du signal SOₘ₂₀ est supérieure à la puissance du signal SOₘ₆. Par exemple, la puissance du signal SOₘ₂₀ est cinq fois ou dix fois supérieure à la puissance du signal SOₘ₆. Cela permet de réduire encore plus la largeur Δv_{SL}. De façon plus générale, le rapport de puissance entre les signaux SOₘ₆ et SOₘ₂₀ est choisi entre 0,0001 et 0,9999 selon les besoins.

### Variantes de la boucle d'asservissement :

D'autres modes de réalisation de l'actionneur 72 sont possibles. Par exemple, une autre technique consiste à modifier la densité de porteurs de charge dans le guide d'onde qui forme l'anneau 60, et donc l'indice de réfraction du guide d'onde. Cette technique est par exemple décrite dans l'article suivant : Giovanni Beninca de Farias et. Al. « Up to 64-QAM Modulation of a Silicon-Ring-Resonator-Modulator », OSA 2014.

Dans une autre variante, la boucle 70 utilise le même actionneur que celui du modulateur 100 et non pas l'actionneur 72. Dans ce cas, le modulateur 100 comporte un sommateur ou un amplificateur-sommateur qui additionne les signaux électriques générés par, respectivement, les circuits 82 et 106 avant d'envoyer le résultat de cette sommation sur l'entrée de l'actionneur 104. Dans ce cas, l'actionneur 72 peut être omis.

La boucle 70 peut fonctionner en utilisant le signal optique filtré à l'aide du bord descendant, au lieu du bord montant, du filtre 30. Dans ce cas, la boucle 70 comporte en plus un inverseur pour inverser le signal électrique mesuré par le photodétecteur 76.

La boucle 70 peut utiliser un filtre optique supplémentaire indépendant du filtre 30 pour générer un signal optique dont la puissance est représentative de l'écart entre les fréquences v_{b} et v₀. Par exemple, ce filtre supplémentaire est identique au filtre 30 et raccordé, en parallèle, à la sortie 18. Dans ce cas, la boucle 70 n'est pas raccordée à la sortie 36 du filtre 30 mais à la sortie de ce filtre supplémentaire. Le filtre supplémentaire est associé à un actionneur supplémentaire identique à l'actionneur 72. Le signal SE₇₄ généré par le circuit 82 est transmis à la fois à l'entrée 74 de l'actionneur 72 et à l'entrée de commande de l'actionneur supplémentaire.

En variante, le photodétecteur 76 est raccordé à la sortie 34 du filtre 30 au lieu d'être raccordé à la sortie 36. Dans ce cas, par exemple, la table T₈₂ doit être modifiée en conséquence. En effet, les signaux SO₃₄ et SO₃₆ sont complémentaires. Typiquement, le signal SO₃₆ est l'inverse du signal SO₃₄. Il faut donc adapter la boucle 70 à cette inversion du signal d'entrée.

### Variantes de la boucle de rétroaction :

La boucle 20 peut être dimensionnée pour que sa fréquence f_{c20} soit inférieure à la largeur Δv_{SL0}.

En variantes, au lieu d'utiliser le bord descendant du filtre optique 30 pour obtenir le signal optique SO₃₄, c'est le bord montant du filtre optique qui est utilisé. Dans ce cas, par exemple, pour obtenir une rétroaction négative, la boucle de rétroaction comporte en plus un inverseur électrique qui inverse le signe du signal électrique mesuré par le photodétecteur 90. Par exemple, à cet effet, l'amplificateur 96 est remplacé par un amplificateur-inverseur.

Le filtre 98 ou 154 ou 204 peut être placé ailleurs dans la boucle de rétroaction. Par exemple, il peut être placé après l'amplificateur 96.

Chaque filtre électrique peut être composé d'un seul filtre électrique ou de plusieurs filtres électriques raccordés en série.

Selon le mode de réalisation de la boucle 70, la partie du spectre de puissance du signal SO₃₄ principalement générée par cette boucle 70 peut se présenter sous la forme d'une raie ou d'une succession de raies distinctes et comprises entre 0 Hz et f_{c70}. On note F_{lock} la composante fondamentale de la partie du spectre générée par la boucle 70 et kF_{lock} les harmoniques de rang supérieur à un de cette partie du spectre, où k est un numéro d'ordre entier strictement supérieur à un. Dans ce cas, le filtre 98 peut être remplacé par un filtre en peigne qui qui comporte au moins une première et une seconde bandes interdites espacées l'une de l'autre par une bande passante. La première bande interdite contient la fréquence 0 Hz et la seconde bande interdite contient la fréquence F_{lock}. Ce filtre en peigne peut en plus comporter des bandes interdites supplémentaires centrées sur certains des harmoniques kF_{lock}. Dans le même cas, de façon similaire, le filtre 154 peut aussi être remplacé dans le même filtre en peigne sauf que la première bande interdite peut être omise. Toujours dans ce cas, la bande interdite 212 peut être remplacer par plusieurs bandes interdites distinctes centrées sur 0 Hz et F_{lock} et, éventuellement, plusieurs des harmoniques kF_{lock}.

Dans une variante simplifiée du filtre 204, à l'exception de la bande interdite 210₁, les autres bandes interdites 210ᵢ peuvent être omises. En effet, l'amplitude des composantes fréquentielle du spectre du signal SEₘ aux harmoniques, autres que la fréquence fondamentale, est généralement beaucoup plus faible. Dès lors leur élimination par la boucle 20 n'est pas nécessairement un problème.

### Variantes communes aux boucles d'asservissement et de rétroaction :

D'autres modes de réalisation du filtre optique sont possibles. Par exemple, le filtre optique peut prendre d'autres formes que celle d'un filtre à anneau résonant. Ainsi, à titre d'illustration, le filtre 30 peut être remplacé par un filtre connu sous l'acronyme GACC (« Grating-Assisted Contra-directional Coupler »). Un tel filtre GACC est bien connu de l'homme du métier. Il est par exemple décrit dans l'article suivant: Wei Shi, et. Al: « Silicon photonic grating-assisted, contra-directional couplers », Vol. 21, No. 3, OPTICS EXPRESS 3633, 11/02/2013. L'entrée et les sorties d'un filtre GACC portent les mêmes noms que celles décrites pour le filtre 30 et sont utilisées de la même manière.

Dans un autre mode de réalisation, le filtre 30 est remplacé par un filtre mettant en œuvre plusieurs anneaux. Un tel filtre à plusieurs anneaux est décrit dans l'article suivant : Mattia Mancinelli, et. Al. : « Optical characterization of a SCISSOR device », Vol. 19, No. 14, OPTICS EXPRESS 13664, 4/07/2011. Là encore les ports utilisés portent le mêmes noms que ceux décrits pour le filtre 30 est sont utilisés de la même manière.

Il est aussi possible d'utiliser un filtre optique dont la bande passante comporte un seul bord montant ou un seul bord descendant. Par exemple, le filtre optique est dans ce cas un filtre optique passe-haut ou passe-bas. L'émetteur fonctionne alors comme décrit précédemment sauf qu'il existe qu'un seul bord montant ou descendant.

En variantes, le point de fonctionnement ne correspond pas au point pour lequel la valeur absolue de la pente du bord du spectre de transmission est maximale. Par exemple, le point de fonctionnement est choisie différemment et correspond à un autre point du bord montant ou descendant où la pente n'est pas maximale. Également en variante, il n'est pas nécessaire que le point de fonctionnement corresponde à un point d'inflexion du bord montant ou descendant.

L'élimination de la composante continue, du bruit d'intensité et de la modulation résiduelle d'intensité du signal SO₃₄ telle que décrit dans le cas de l'émetteur 130 peut être mise en œuvre dans tous les autres modes de réalisation décrits ici.

Le mode de réalisation décrit en référence à la figure 6 peut être combiné avec l'un quelconque des autres de modes de réalisation comportant le modulateur 100. Dans ce cas, le mode de réalisation obtenu élimine les composantes fréquentielles du courant d'induction produit aux multiples entiers de la fréquence fondamentale f_{b} à la fois en utilisant le modulateur 100 et le filtre 204.

### Autres variantes :

En variante, l'émetteur 2 comporte l'entrée 4 et une entrée supplémentaire destinée elle aussi à recevoir le signal SEₘ. Dans ce cas, par exemple, l'entrée 12 de la source laser 10 est seulement raccordée à l'entrée 4 et l'entrée 102 du modulateur 100 est seulement raccordée à cette entrée supplémentaire. Pour que cet émetteur fonctionne correctement, le signal électrique SEₘ est alors transmis simultanément sur l'entrée 4 et sur cette entrée supplémentaire.

Les modes de réalisation ont été décrits dans le cas particulier d'un émetteur d'un signal optique modulé en fréquence. Toutefois, tout ce qui a été décrit ici s'applique au cas d'un émetteur d'un signal optique non modulé en fréquence. Lorsque la fréquence v_{SL} n'est pas modulée, le modulateur 100 et les bandes interdites 210ᵢ du filtre 204 peuvent être omis. Dans le cas où la fréquence v_{SL} n'est pas modulée, il est possible de faire fonctionner la boucle 70 uniquement par intermittence. Par exemple, la boucle 70 est uniquement active pendant une phase d'initialisation de l'émetteur. Ensuite, la boucle 70 est éteinte. Lorsqu'elle est éteinte, elle n'agit plus sur le filtre optique 30.

Le composant 136 et le soustracteur 150 peuvent être mis en œuvre dans des boucles de rétroaction conçues pour réduire la largeur Δv_{SL} indépendamment de la boucle 70. Par exemple, ce composant 136 et ce soustracteur 150 peuvent être mis en œuvre dans un émetteur identique à celui de la figure 5 mais dans lequel la boucle 70 est omise. Ceci est par exemple possible si la température de la source laser 10 et du filtre 30 est stabilisée par un circuit de refroidissement qui la maintient constante. Lorsque la boucle 70 est omise, il n'est pas nécessaire que la boucle de rétroaction comporte un filtre qui atténue ou élimine sélectivement les composantes fréquentielles produites par cette boucle 70.

Le filtre 204 et/ou le modulateur 100 peuvent être mis en œuvre indépendamment de la boucle 70. Par exemple, dans tous les modes de réalisation décrits ici, la boucle 70 peut être omise. Comme indiqué ci-dessus, ceci est tout à fait possible si les perturbations lentes qui affecte le filtre 30 sont négligeables.

### Avantages des modes de réalisation décrits :

L'utilisation de la boucle 70 pour compenser les écarts entre les fréquences v_{b} et v₀ dus à des perturbations lentes telles qu'une variation de températures ou des vibrations permet de stabiliser le fonctionnement de l'émetteur sans avoir recours à des moyens plus complexes et encombrants pour atténuer ces perturbations. Par exemple, il n'est pas nécessaire d'utiliser un refroidisseur pour maintenir la température du filtre optique égale à la température de la source laser.

De plus, le fait d'utiliser un filtre optique dont la bande passante comprend un bord situé sur la fréquence v₀ permet d'extraire une grandeur physique représentative de l'écart entre les fréquences v_{b} et v₀ à l'aide d'un composant optique bien plus compact qu'un réseau de Mach-Zender dont l'une des branches mesure 60 m de long.

Le fait d'utiliser un même filtre pour éliminer du courant d'injection la composante continue et les composantes fréquentielles inférieures ou égale à la fréquence f_{c70}, permet de simplifier la réalisation de l'émetteur.

Le fait d'utiliser le même filtre 30 pour générer le signal optique dont la puissance est mesurée, respectivement, par les photodétecteurs 76 et 90 limite le nombre de composants de l'émetteur.

L'utilisation du modulateur 100 et/ou du filtre électrique 204 permet de retirer du courant d'injection produit les composantes fréquentielles générées par la modulation de fréquence. Ainsi, la boucle de rétroaction n'annule pas et ne compense pas la modulation de la fréquence v_{SL} provoquée par le signal SEₘ. Il est donc possible à la fois de réduire la largeur Δv_{SL} tout en modulant la fréquence v_{SL}. De plus, cela fonctionne même si la fréquence fondamentale du signal SEₘ est inférieure à la fréquence de coupure f_{c20} de la boucle de rétroaction.

Utiliser un anneau résonnant permet de limiter encore plus l'encombrement de l'émetteur. En effet, à performance égale, à un anneau résonant, est plus petit que, par exemple, un filtre GACC.

L'utilisation du composant 136 et du soustracteur 150 permet de produire un courant d'injection dont l'intensité est pratiquement indépendante du bruit d'intensité et de la modulation résiduelle d'intensité susceptible d'exister en parallèle du bruit de fréquence. Cela améliore le fonctionnement de l'émetteur et permet notamment de réduire encore plus la largeur Δv_{SL}.

Choisir comme point de fonctionnement, le point du bord du filtre optique où la valeur absolue de la pente est maximale permet d'augmenter la sensibilité des boucles 20 et 70.

## Revendications

1. Émetteur (2 ; 130 ; 200) d'un signal optique monochromatique, cet émetteur comportant :
- une source laser (10 ; 250) à semi-conducteur apte à émettre le signal optique à une fréquence v_{SL}, cette source laser comportant au moins une entrée (14) de commande pour recevoir un courant d'injection apte à modifier la fréquence v_{SL} et au moins une sortie (18) par laquelle est émis le signal optique, cette source laser émettant le signal optique à une fréquence v₀ en absence de courant d'injection,
- une boucle (20 ; 132 ; 202) de rétroaction apte à produire un courant d'injection apte réduire la largeur de raie du signal optique, cette boucle de rétroaction étant raccordée, d'un côté, à la sortie (18) de la source laser et, d'un côté opposé, à l'entrée (14) de commande de la source laser pour injecter dans la source laser le courant d'injection produit, cette boucle de rétroaction comportant à cet effet un filtre optique (30) présentant un spectre de transmission comportant une bande passante, cette bande passante étant délimitée, dans le spectre de transmission, au moins d'un côté par un bord (42, 48) qui varie de façon continûment croissante ou décroissante sur un intervalle de fréquences contenant la fréquence v₀, ce bord contenant un point (43, 49) de fonctionnement situé à une position prédéterminée le long du bord et correspondant à une fréquence vb contenue dans l'intervalle de fréquences, ce filtre optique étant raccordé à la sortie (18) de la source laser pour recevoir le signal optique et comportant une sortie (34) par laquelle est émise le signal optique filtré et à partir duquel le courant d'injection est produit,
**caractérisé en ce que** :
- l'émetteur comporte, en plus de la boucle (20 ; 132 ; 202) de rétroaction, une boucle (70) d'asservissement de la fréquence vb sur la fréquence v₀, et
- la boucle (20 ; 132 ; 202) de rétroaction comporte un filtre électrique (98 ; 154 ; 204) apte à atténuer sélectivement, dans le courant d'injection produit, l'amplitude des composantes fréquentielles générées par la boucle (70) d'asservissement.

2. Émetteur selon la revendication 1, dans lequel le filtre électrique (98 ; 204) est également apte à atténuer la composante continue du signal électrique, l'atténuation de la composante continue du signal électrique étant supérieure à - 3 dB.

3. Émetteur selon l'une quelconque des revendications précédentes, dans lequel le filtre électrique (98 ; 154 ; 204) présente une bande interdite (212) à l'intérieur de laquelle l'atténuation du signal électrique est supérieure à - 3 dB, cette bande interdite s'étendant continûment depuis une fréquence basse jusqu'à une fréquence haute, la fréquence basse étant égale à 0 Hz ou inférieure à 100 Hz et la fréquence haute étant comprise dans l'intervalle [f_{c70}; 1,3f_{c70}], où f_{c70} est la fréquence de coupure à - 3dB de la boucle (70) d'asservissement.

4. Émetteur selon l'une quelconque des revendications 1 à 2, dans lequel le filtre électrique présente une bande interdite à l'intérieur de laquelle l'atténuation du signal électrique est supérieure à - 3 dB, cette bande interdite s'étendant continûment depuis une fréquence basse jusqu'à une fréquence haute, la fréquence basse étant comprise dans un intervalle [0,7F_{lock} ; 0,98F_{lock}] et la fréquence haute étant comprise dans un intervalle [1,02F_{lock} ; 1,3F_{lock}], où F_{lock} est la fréquence fondamentale de la partie du spectre du signal optique filtré générée par la boucle d'asservissement.

5. Émetteur selon l'une quelconque des revendications précédentes, dans lequel la boucle (70) d'asservissement comporte :
- un actionneur (72) comportant une entrée (74) de commande, cet actionneur (72) étant apte à induire un déplacement du bord (48) de la bande passante du filtre optique (30) en fonction du signal de commande reçu sur son entrée (74) de commande,
- un photodétecteur (76) apte à générer un signal électrique représentatif de l'écart entre les fréquences v_{b} et v₀, et
- un circuit (82) de commande apte, à partir du signal électrique représentatif de l'écart entre les fréquences v_{b} et v₀, à générer un signal de commande sur l'entrée de commande de l'actionneur (72) qui induit un déplacement du bord (48) de la bande passante du filtre optique réduisant cet écart entre les fréquences v_{b} et v₀.

6. Émetteur selon la revendication 5, dans lequel le photodétecteur (76) est raccordé à la même sortie (34) ou à une autre sortie (36) du filtre optique (30) de manière à générer un signal électrique représentatif de l'écart entre les fréquences v_{b} et v₀.

7. Émetteur (2 ; 130 ; 200) selon l'une quelconque des revendications précédentes apte en plus à moduler la fréquence du signal optique, dans lequel :
- la source laser (10 ; 250) est apte à recevoir un signal électrique de modulation et, en réponse, à déplacer la fréquence du signal optique en fonction du signal électrique de modulation reçu, et
- l'émetteur comporte en plus :
• un modulateur (100) comportant une entrée (102) de commande destinée à recevoir le signal électrique de modulation, ce modulateur étant apte à induire un déplacement du bord (48) de la bande passante du filtre optique (30), identique au déplacement appliqué à la fréquence v_{SL} du signal optique lorsque le signal électrique de modulation reçu sur son entrée (102) de commande est identique au signal électrique de modulation reçu par la source laser (10 ; 250), ou
• le filtre électrique (204) est également apte à atténuer sélectivement, dans le courant d'injection produit, au moins l'amplitude d'une composante fréquentielle à une fréquence f_{b}, où la fréquence f_{b} est la fréquence fondamentale du signal électrique de modulation.

8. Émetteur selon la revendication 7, dans lequel le filtre électrique (204) comporte un filtre en peigne présentant plusieurs bandes passantes (208ᵢ) espacées les unes des autres par des bandes interdites (210ᵢ) dans lesquelles l'atténuation du signal électrique est supérieure à - 3 dB, chacune de ces bandes interdites contenant un multiple entier respectif de la fréquence f_{b}.

9. Émetteur selon l'une quelconque des revendications précédentes, dans lequel le filtre optique (30) comporte un anneau résonant.

10. Émetteur selon l'une quelconque des revendications précédentes, dans lequel le point (49) de fonctionnement prédéterminé est le point du bord (48) du spectre de transmission pour lequel la valeur absolue de la pente de ce bord (48) est maximale.

11. Émetteur selon l'une quelconque des revendications précédentes, dans lequel la boucle (132) de rétroaction comporte :
- un composant (136) apte à générer un signal électrique, dit de « référence », représentatif de la puissance du signal optique avant que celui-ci ne soit filtré par le filtre optique, ce composant comportant à cet effet :
• un atténuateur (142) de puissance équipé :
- d'une entrée (138) raccordée à la sortie de la source laser en amont du filtre optique (30),
- d'une sortie (146) sur laquelle est délivré un signal optique identique, à un coefficient d'atténuation de puissance près, au signal reçu sur son entrée (138), ce coefficient d'atténuation de puissance de l'atténuateur étant égal au coefficient d'atténuation du filtre optique, (30) et
• un photodétecteur (144) raccordé à la sortie de l'atténuateur (142) et comportant une sortie (140) sur laquelle est émis le signal électrique de référence obtenu à partir du signal optique atténué délivré sur la sortie de l'atténuateur (142),
- un soustracteur (150) apte à soustraire, au courant d'injection produit, ce signal électrique de référence.

12. Émetteur selon l'une quelconque des revendications précédentes, dans lequel, dans le spectre de transmission, le bord (48) de la bande passante du filtre optique est un bord descendant.

13. Émetteur selon l'une quelconque des revendications précédentes, dans lequel la boucle de rétroaction comporte un photodétecteur (90) apte à convertir le signal optique filtré en un signal électrique mesuré proportionnel à la puissance du signal optique filtré et à partir duquel le courant d'injection est produit, ce photodétecteur étant raccordé à la sortie (34) du filtre optique (30) pour recevoir le signal optique filtré et comportant une sortie (94) sur laquelle est émis le signal électrique mesuré.

14. Émetteur selon l'une quelconque des revendications précédentes, dans lequel la source laser (10) et le filtre optique (30) sont fabriqués et intégrés sur un même substrat.

## Patentansprüche

1. Sender (2; 130; 200) eines monochromatischen optischen Signals, wobei dieser Sender umfasst:
- eine Halbleiterlaserquelle (10; 250), die geeignet ist, das optische Signal mit einer Frequenz v_{SL} zu senden, wobei diese Laserquelle mindestens einen Steuerungseingang (14) zum Empfangen eines Injektionsstroms, der geeignet ist, die Frequenz v_{SL} zu ändern, und mindestens einen Ausgang (18), über den das optische Signal gesendet wird, umfasst, wobei diese Laserquelle das optische Signal mit einer Frequenz v₀ sendet, wenn kein Injektionsstrom vorhanden ist,
- eine Rückkopplungsschleife (20; 132; 202), die geeignet ist, einen Injektionsstrom zu erzeugen, der geeignet ist, die Linienbreite des optischen Signals zu verringern, wobei diese Rückkopplungsschleife auf einer Seite an den Ausgang (18) der Laserquelle angeschlossen ist, und auf einer entgegengesetzten Seite an den Steuerungseingang (14) der Laserquelle, um den erzeugten Injektionsstrom in die Laserquelle zu injizieren, wobei diese Rückkopplungsschleife zu diesem Zweck ein optisches Filter (30) umfasst, das ein Übertragungsspektrum aufweist, das einen Durchlassbereich umfasst, wobei dieser Durchlassbereich in dem Übertragungsspektrum mindestens auf einer Seite von einem Rand (42, 48) begrenzt wird, der sich auf einem Frequenzintervall, das die Frequenz v₀ enthält, stetig wachsend oder fallend ändert, wobei dieser Rand einen Betriebspunkt (43, 49) enthält, der sich an einer vorbestimmten Position entlang des Randes befindet und einer Frequenz v_{b} entspricht, die in dem Frequenzintervall enthalten ist, wobei dieses optische Filter an den Ausgang (18) der Laserquelle angeschlossen ist, um das optische Signal zu empfangen, und einen Ausgang (34) umfasst, über den das gefilterte optische Signal gesendet wird und von dem aus der Injektionsstrom erzeugt wird,
**dadurch gekennzeichnet, dass**:
- der Sender zusätzlich zu der Rückkopplungsschleife (20; 132; 202) eine Schleife (70) zur Regelung der Frequenz v_{b} auf die Frequenz v₀ umfasst, und
- die Rückkopplungsschleife (20; 132; 202) ein elektrisches Filter (98; 154; 204) umfasst, das geeignet ist, in dem erzeugten Injektionsstrom die Amplitude der Frequenzkomponenten, die von der Regelschleife (70) erzeugt werden, selektiv zu dämpfen.

2. Sender nach Anspruch 1, wobei das elektrische Filter (98; 204) ebenfalls geeignet ist, die stetige Komponente des elektrischen Signals zu dämpfen, wobei die Dämpfung der stetigen Komponente des elektrischen Signals größer als -3 dB ist.

3. Sender nach einem der vorhergehenden Ansprüche, wobei das elektrische Filter (98; 154; 204) eine Bandlücke (212) aufweist, in deren Innerem die Dämpfung des elektrischen Signals größer als -3 dB ist, wobei sich diese Bandlücke durchgehend von einer niedrigen Frequenz bis zu einer hohen Frequenz erstreckt, wobei die niedrige Frequenz gleich 0 Hz oder kleiner als 100 Hz ist und die hohe Frequenz im Intervall [f_{c70}; 1,3 f_{c70}] liegt, wobei f_{c70} die Grenzfrequenz bei -3 dB der Regelschleife (70) ist.

4. Sender nach einem der Ansprüche 1 bis 2, wobei das elektrische Filter eine Bandlücke aufweist, in deren Innerem die Dämpfung des elektrischen Signals größer als -3 dB ist, wobei sich diese Bandlücke durchgehend von einer niedrigen Frequenz bis zu einer hohen Frequenz erstreckt, wobei die niedrige Frequenz in einem Intervall [0,7 F_{lock}; 0,98 F_{lock}] liegt und die hohe Frequenz in einem Intervall [1,02 F_{lock}; 1,3 F_{lock}] liegt, wobei F_{lock} die Grundfrequenz des Teils des Spektrums des gefilterten optischen Signals ist, der von der Regelschleife erzeugt wird.

5. Sender nach einem der vorhergehenden Ansprüche, wobei die Regelschleife (70) umfasst:
- einen Aktuator (72), der einen Steuerungseingang (74) umfasst, wobei dieser Aktuator (72) geeignet ist, eine Verschiebung des Randes (48) des Durchlassbereichs des optischen Filters (30) in Abhängigkeit von dem an seinem Steuerungseingang (74) empfangenen Steuersignal zu bewirken,
- einen Photodetektor (76), der geeignet ist, ein elektrisches Signal zu erzeugen, das für die Abweichung zwischen den Frequenzen v_{b} und v₀ repräsentativ ist, und
- einen Steuerkreis (82), der geeignet ist, aus dem elektrischen Signal, das für die Abweichung zwischen den Frequenzen v_{b} und v₀ repräsentativ ist, ein Steuersignal am Steuerungseingang des Aktuators (72) zu erzeugen, welches eine Verschiebung des Randes (48) des Durchlassbereichs des optischen Filters bewirkt, die diese Abweichung zwischen den Frequenzen v_{b} und v₀ verringert.

6. Sender nach Anspruch 5, wobei der Photodetektor (76) an denselben Ausgang (34) oder an einen anderen Ausgang (36) des optischen Filters (30) angeschlossen ist, um ein elektrisches Signal zu erzeugen, das für die Abweichung zwischen den Frequenzen v_{b} und v₀ repräsentativ ist.

7. Sender (2; 130; 200) nach einem der vorhergehenden Ansprüche, welcher außerdem geeignet ist, die Frequenz des optischen Signals zu modulieren, wobei:
- die Laserquelle (10; 250) geeignet ist, ein elektrisches Modulationssignal zu empfangen und, in Reaktion darauf, die Frequenz des optischen Signals in Abhängigkeit von dem empfangenen elektrischen Modulationssignal zu verschieben, und
- der Sender außerdem umfasst:
• einen Modulator (100), der einen Steuerungseingang (102) umfasst, der dazu bestimmt ist, das elektrische Modulationssignal zu empfangen, wobei dieser Modulator geeignet ist, eine Verschiebung des Randes (48) des Durchlassbereichs des optischen Filters (30) zu bewirken, die mit der auf die Frequenz v_{SL} des optischen Signals angewendeten Verschiebung identisch ist, wenn das an seinem Steuerungseingang (102) empfangene elektrische Modulationssignal mit dem durch die Laserquelle (10; 250) empfangenen elektrischen Modulationssignal identisch ist, oder
• das elektrische Filter (204) auch geeignet ist, in dem erzeugten Injektionsstrom wenigstens die Amplitude einer Frequenzkomponente mit einer Frequenz f_{b} selektiv zu dämpfen, wobei die Frequenz f_{b} die Grundfrequenz des elektrischen Modulationssignals ist.

8. Sender nach Anspruch 7, wobei das elektrische Filter (204) ein Kammfilter umfasst, das mehrere Durchlassbereiche (208ᵢ) aufweist, die durch Bandlücken (210ᵢ), in welchen die Dämpfung des elektrischen Signals größer als -3 dB ist, voneinander beabstandet sind, wobei jede dieser Bandlücken ein jeweiliges ganzzahliges Vielfaches der Frequenz f_{b} enthält.

9. Sender nach einem der vorhergehenden Ansprüche, wobei das optische Filter (30) einen Ringresonator umfasst.

10. Sender nach einem der vorhergehenden Ansprüche, wobei der vorbestimmte Betriebspunkt (49) der Punkt des Randes (48) des Übertragungsspektrums ist, für welchen der absolute Betrag des Anstiegs dieses Randes (48) maximal ist.

11. Sender nach einem der vorhergehenden Ansprüche, wobei die Rückkopplungsschleife (132) umfasst:
- eine Komponente (136), die geeignet ist, ein elektrisches Signal zu erzeugen, Referenzsignal genannt, das für die Leistung des optischen Signals, bevor dieses durch das optische Filter gefiltert wird, repräsentativ ist, wobei diese Komponente zu diesem Zweck umfasst:
• ein Leistungsdämpfungsglied (142), welches ausgestattet ist:
- mit einem Eingang (138), der vor dem optischen Filter (30) an den Ausgang der Laserquelle angeschlossen ist,
- mit einem Ausgang (146), an welchem ein optisches Signal geliefert wird, das, abgesehen von einem Leistungsdämpfungsfaktor, mit dem an seinem Eingang (138) empfangenen Signal identisch ist, wobei dieser Leistungsdämpfungsfaktor gleich dem Dämpfungsfaktor des optischen Filters (30) ist, und
• einen Photodetektor (144), der an den Ausgang des Dämpfungsgliedes (142) angeschlossen ist und einen Ausgang (140) umfasst, an welchem das elektrische Referenzsignal gesendet wird, das aus dem gedämpften optischen Signal erhalten wird, das am Ausgang des Dämpfungsgliedes (142) geliefert wird,
- einen Subtrahierer (150), der geeignet ist, dieses elektrische Referenzsignal von dem erzeugten Injektionsstrom zu subtrahieren.

12. Sender nach einem der vorhergehenden Ansprüche, wobei in dem Übertragungsspektrum der Rand (48) des Durchlassbereichs des optischen Filters ein fallender Rand ist.

13. Sender nach einem der vorhergehenden Ansprüche, wobei die Rückkopplungsschleife einen Photodetektor (90) umfasst, der geeignet ist, das gefilterte optische Signal in ein gemessenes elektrisches Signal umzuwandeln, das zur Leistung des gefilterten optischen Signals proportional ist und aus dem der Injektionsstrom erzeugt wird, wobei dieser Photodetektor an den Ausgang (34) des optischen Filters (30) angeschlossen ist, um das gefilterte optische Signal zu empfangen, und einen Ausgang (94) umfasst, an welchem das gemessene elektrische Signal gesendet wird.

14. Sender nach einem der vorhergehenden Ansprüche, wobei die Laserquelle (10) und das optische Filter (30) auf ein und demselben Substrat hergestellt und integriert sind.

## Claims

1. Emitter (2; 130; 200) of a monochromatic optical signal, this emitter comprising:
- a semiconductor laser source (10; 250) that is able to emit the optical signal at a frequency v_{SL}, this laser source comprising at least one control input (14) for receiving an injection current able to modify the frequency v_{SL} and at least one output (18) via which the optical signal is emitted, this laser source emitting the optical signal at a frequency v₀ in the absence of injection current, and
- a feedback loop (20; 132; 202) able to produce an injection current that is able to decrease the linewidth of the optical signal, this feedback loop being connected, on the one hand, to the output (18) of the laser source and, on the other hand, to the control input (14) of the laser source in order to inject into the laser source the produced injection current, this feedback loop comprising to this end an optical filter (30) having a transmission spectrum comprising a pass band, this pass band being bounded, in the transmission spectrum, at least on one side by a rising or falling edge (42, 48) that continuously varies over a frequency interval containing the frequency v₀, this edge containing an operating point (43, 49) that is located at a preset position along the edge and that corresponds to a frequency v_{b} contained in the frequency interval, this optical filter being connected to the output (18) of the laser source in order to receive the optical signal and comprising an output (34) via which the filtered optical signal on the basis of which the injection current is produced is emitted, **characterized in that**:
- the emitter comprises, in addition to the feedback loop (20; 132; 202), a loop (70) for automatically controlling the frequency v_{b} to the frequency v₀, and
- the feedback loop (20; 132; 202) comprises an electrical filter (98; 154; 204) that is able to selectively attenuate, in the produced injection current, the amplitude of the frequency components generated by the automatic-control loop (70).

2. Emitter according to Claim 1, wherein the electrical filter (98; 204) is also able to attenuate the DC component of the electrical signal, the attenuation of the DC component of the electrical signal being higher than -3 dB.

3. Emitter according to either one of the preceding claims, wherein the electrical filter (98; 154; 204) has a stop band (212) inside of which the attenuation of the electrical signal is higher than -3 dB, this stop band extending continuously from a low frequency to a high frequency, the low frequency being equal to 0 Hz or lower than 100 Hz and the high frequency being comprised in the interval [f_{c70}; 1.3f_{c70}], where f_{c70} is the -3 dB cut-off frequency of the automatic-control loop (70).

4. Emitter according to either one of Claims 1 and 2, wherein the electrical filter has a stop band inside of which the attenuation of the electrical signal is higher than -3 dB, this stop band extending continuously from a low frequency to a high frequency, the low frequency being comprised in an interval [0.7F_{lock}; 0.98F_{lock}] and the high frequency being comprised in an interval [1.02F_{lock}; 1.3F_{lock}], where F_{lock} is the fundamental frequency of that portion of the spectrum of the filtered optical signal which is generated by the automatic-control loop.

5. Emitter according to any one of the preceding claims, wherein the automatic-control loop (70) comprises:
- an actuator (72) comprising a control input (74), this actuator (72) being able to induce a movement of the edge (48) of the pass band of the optical filter (30) depending on the control signal received by its control input (74),
- a photodetector (76) able to generate an electrical signal representative of the difference between the frequencies v_{b} and v₀, and
- a control circuit (82) able, on the basis of the electrical signal representative of the difference between the frequencies v_{b} and v₀, to generate, on the control input of the actuator (72), a control signal that induces a movement of the edge (48) of the pass band of the optical filter, decreasing this difference between the frequencies v_{b} and v₀.

6. Emitter according to Claim 5, wherein the photodetector (76) is connected to the same output (34) or to another output (36) of the optical filter (30) so as to generate an electrical signal representative of the difference between the frequencies v_{b} and v₀.

7. Emitter (2; 130; 200) according to any one of the preceding claims and able, in addition, to modulate the frequency of the optical signal, wherein:
- the laser source (10; 250) is able to receive an electrical modulation signal and, in response, to move the frequency of the optical signal depending on the received electrical modulation signal, and
- the emitter in addition comprises
• a modulator (100) comprising a control input (102) that is intended to receive the electrical modulation signal, this modulator being able to induce a movement of the edge (48) of the pass band of the optical filter (30) that is identical to the movement applied to the frequency v_{SL} of the optical signal when the electrical modulation signal received by its control input (102) is identical to the electrical modulation signal received by the laser source (10; 250), or
• the electrical filter (204) is also able to selectively attenuate, in the produced injection current, at least the amplitude of a frequency component at a frequency f_{b}, where the frequency f_{b} is the fundamental frequency of the electrical modulation signal.

8. Emitter according to Claim 7, wherein the electrical filter (204) comprises a comb filter having a plurality of pass bands (208ᵢ) that are spaced apart from one another by stop bands (210ᵢ) in which the attenuation of the electrical signal is higher than -3 dB, each of these stop bands containing a respective integer multiple of the frequency f_{b}.

9. Emitter according to any one of the preceding claims, wherein the optical filter (30) comprises a ring resonator.

10. Emitter according to any one of the preceding claims, wherein the preset operating point (49) is the point of the edge (48) of the transmission spectrum for which the absolute value of the slope of this edge (48) is maximal.

11. Emitter according to any one of the preceding claims, wherein the feedback loop (132) comprises:
- a component (136) able to generate an electrical signal, called the "reference signal", that is representative of the power of the optical signal before the latter is filtered by the optical filter, this component comprising to this end:
• a power attenuator (142) equipped:
- with an input (138) that is connected to the output of the laser source upstream of the optical filter (30), and
- with an output (146) from which is delivered an optical signal that is identical, to within a power attenuation coefficient, to the signal received by its input (138), this power attenuation coefficient of the attenuator being equal to the attenuation coefficient of the optical filter, (30) and
• a photodetector (144) that is connected to the output of the attenuator (142) and that includes an output (140) from which is emitted the reference electrical signal obtained on the basis of the attenuated optical signal delivered to the output of the attenuator (142), and
- a subtractor (150) able to subtract, from the produced injection current, this reference electrical signal.

12. Emitter according to any one of the preceding claims, wherein, in the transmission spectrum, the edge (48) of the pass band of the optical filter is a falling edge.

13. Emitter according to any one of the preceding claims, wherein the feedback loop comprises a photodetector (90) that is able to convert the filtered optical signal into a measured electric signal that is proportional to the power of the filtered optical signal and on the basis of which the injection current is produced, this photodetector being connected to the output (34) of the optical filter (30) in order to receive the filtered optical signal and comprising an output (94) from which the measured electrical signal is emitted.

14. Emitter according to any one of the preceding claims, wherein the laser source (10) and the optical filter (30) are fabricated in and integrated into the same substrate.
